# EUROPEAN PATENT APPLICATION

(11) **EP 4 760 281 A1**
(43) Date of publication of application: **17.06.2026**
(21) Application number: 25150955.0
(22) Date of filing: 09.01.2025
(51) Int. Cl.: G01R 31/08, G01R 31/52

(54) **METHOD OF DETECTING A FAULT IN A DEDICATED METALLIC RETURN LINE OR IN AN ELECTRODE LINE IN A BIPOLAR HVDC SYSTEM AND BIPOLAR HVDC SYSTEM COMPRISING A FAULT DETECTOR**

(30) Priority: 13.12.2024 IN 202441098757
(71) Applicant: Hitachi Energy Ltd, 8050 Zürich (CH)
(72) Inventor: Jiang Häfner, Ying, 771 42 Ludvika (SE); Choudhury, Saurav, 560067 Bengaluru, Karnataka (IN); Abdalrahman, Adil, 702 18 Örebro (SE)
(74) Representative: Epping - Hermann - Fischer

(57) **Abstract**

A method of detecting a fault in a DMR line (6a-6e) or in an electrode line (13) in a bipolar HVDC system (1) comprises creating an AC current (iₕₐᵣₘ) in the DMR line (6a-6e) or in the electrode line (13) during bipolar operation of the HVDC system (1), measuring currents (i₁, i₂) at two or more locations in the DMR line (6a-6d) or in the electrode line (13), calculating the difference (D_{RMS}) between the currents (i₁, i₂) and determining if the difference (D_{RMS}) is larger than a pre-defined threshold level (L) for detecting a fault (12) in the DMR line (6a-6e) or in the electrode line (13).

## Description

The present disclosure relates to a method of detecting a fault in a dedicated metallic return (DMR) line or in an electrode line (EL) in a bipolar HVDC (high voltage direct current) system.

The energy transition aimed at decarbonizing the existing power grid leads to an increased application of HVDC transmission systems for integrating renewable energy sources, which are often located far from load centres. Due to constraints related to earth currents and the need for high service availability, a bipolar HVDC system with a dedicated metallic return line (DMR) has become the preferred transmission topology. Instead of a DMR, an electrode line (EL) can be used as a return line.

Multi-Terminal HVDC (MTDC) systems play a crucial role during the energy transition period and in the future carbon-neutral power grid. In an MTDC system, more than two converter stations are connected in a single DC network. MTDC systems can integrate large-scale renewables without compromising power supply quality. This is because MTDC systems provide flexible power flow control, isolation between generation and load, and cost-effective long-distance power transfer.

In a bipolar HVDC system, the DMR line or electrode line provides a return path for current if one of the poles fails or needs maintenance and the system, or a part thereof, is switched into monopolar mode. Furthermore, the DMR line or EL takes up unbalanced currents in bipolar mode. While a DMR line provides a separate line connecting the converter stations, an EL connects a converter to a grounding electrode such that the return path is partially via earth. Using a DMR line instead of earth as a return path reduces the environmental impact associated with ground return currents. A fault in a DMR line or EL, particularly an earth fault, can easily be overlooked in bipolar operation, since the two pole currents are normally balanced such that the current in the DMR line or EL is often very small.

EP 3 547 486 B1 discloses a method for detecting an earth fault in a DMR line, wherein alternating current components are superimposed on direct currents flowing in the DC transmission lines, such that sinusoidal current is generated in the DMR line. In a second step, voltage and current in the DMR line are measured and an impedance value is determined. By determining a characteristic parameter from the impedance value, a fault can be detected and a fault location can be determined.

Embodiments of the disclosure relate to an improved method of detecting a fault in a DMR line or EL in a bipolar HVDC system.

According to a first aspect, a method of detecting a fault in a DMR line or EL in a bipolar HVDC system comprises creating an AC current in the DMR line or EL, measuring the current flowing in the DMR line or EL at least at two or more locations in the DMR line or EL, calculating a difference between the currents at the two or more locations and determining if the difference is larger than a pre-defined threshold level for detecting a fault in the DMR line or in the EL.

Bipolar HVDC systems comprise two transmissions lines and a DMR line or an EL. One end of the transmission lines and the DMR line or the EL is connected to a converter station. In case of a DMR line, the other end may be connected to a further converter station, when the HVDC is a point-to-point system. In case of a multi-terminal HVDC system, the other end may be connected to a switching station. In case of an EL, the other end is connected to a ground electrode. In the HVDC system, each of the converter stations and/or switching stations may be connected to an EL instead which is connected to a ground electrode. The DMR line or EL may be configured as an overhead line. It is also possible that the DMR line or EL is configured as an underground cable. As an example, the DMR line or EL may comprise a subterranean cable.

In the method, current is measured at several locations in the DMR line or EL. In particular, currents may be measured at opposite ends of the DMR line or EL. As an example, for a DMR, current may be measured at converter stations and/or a switching station of the HVDC system. For an EL, current may be measured at one end at the grounding electrode and at the other end at a converter or switching station.

The current in the DMR line or EL may be measured by a control and/or protection device of the converter station and/or switching station. It is also possible to measure the current by a separate device. The current can be measured inside or outside the converter or switching stations. The calculation required for determining a fault may be conducted by the control and/or protection device, e.g. by a fault detector integrated in the device, or by a separate fault detector.

The method may comprise calculating RMS values of the measured currents and determining a difference between the RMS values. Alternatively, instead of RMS values, maximum values and/or absolute values may be used and the difference may be calculated between these current values.

The AC current may be caused by an AC voltage generated by a converter in a converter station. The converter may at the same time generate an DC voltage for causing DC current for transmission in a transmission line. Accordingly, the AC voltage is superimposed on the DC voltage. This has the advantage that further equipment is not required for generating the AC current.

The converter may be a modular multilevel converter (MMC). An MMC comprises multiple identical submodules that are connected in series within each phase leg. Each submodule may contain a capacitor and semiconductor switch (such as IGBTs or MOSFETs). An MMC converter allows regulating AC side voltage and DC side voltage in a decoupled way. Thus, creating an AC harmonic current at the DC side in the DMR line or EL will not affect the power transfer on any of the poles, which allows decoupled AC voltage or current control and DC voltage or current control.

A presence of a fault is detected when the difference between the current values exceeds the threshold value. Exceeding the threshold value may be required for a pre-defined duration for indicating that a fault is present.

As an example, the pre-defined duration may be 0.05 s. It is also possible that the pre-defined duration is between 0.01 s and 0.1 s, for example.

For minimizing undesired disturbances, the AC current injected in the DMR can be selected to be at a low frequency, for example between 10 Hz and 500 Hz. The frequency is below 200 Hz, for example. Furthermore, the AC current can be selected to have a small amplitude. Furthermore, the AC current can be created for a short time duration, for example for a duration between 0.1 s and 1 s. The AC current may be created at regular intervals, e.g., daily, and at a selected specific time, e.g. in the night. The duration of the harmonic current is limited to a duration which is sufficient to evaluate if an earth fault is present in the DMR line or EL. As an example, the duration of the AC current is between 0.1 s and 0.5 s. Thus, regular checking can be performed with minimal impact.

Generally, for the disclosed method, only current measurement in the DMR line or EL is required. Thus, a voltage has not to be measured, which simplifies the process in comparison to determining an impedance. A further advantage is that, if a DMR or EL fault is near a station, the impedance value will be very small, and a fault may remain undetected.

Furthermore, different resonance points may occur in a DMR line or an EL. At these resonance points standing waves can be created at specific frequences. Therefore, an impedance value may not reliably be determined, and a fault detection not ensured by analyzing the impedance.

According to a further aspect, a bipolar HVDC system is disclosed. The HVDC system may comprise any features and characteristics as described in the connection with the method and vice versa. The HVDC system may be configured for creating an AC current in the DMR line or EL, measuring a current in the DMR line or EL at two or more locations in the DMR line or EL, calculating a difference between the currents and determining if the difference is larger than a pre-defined threshold level for detecting a fault in the DMR line or EL . The HVDC system may be configured for creating the AC current during bipolar operation of the HVDC system.

The HVDC system may comprise a first transmission line, a second transmission line, a DMR line or EL and a converter station comprising a converter configured for causing an AC current in the DMR line or EL. The HVDC system may further comprise at least one current measuring device for measuring a current in the DMR line or EL at two or more locations in the DMR line or EL and a fault detector. The fault detector may be configured for calculating RMS values of the measured currents and calculating the difference between the RMS values.

The HVDC system may comprise a DMR line, wherein the fault detector is configured for detecting a fault in the DMR line. Alternatively, the HVDC system may comprise an electrode line, wherein the fault detector is configured for detecting a fault in the electrode line. In an HVDC system comprising an electrode line, the electrode line connects a converter station or switching station to a ground electrode. The current return path is formed by a first electrode line, earth and a second electrode line. For each of the electrode lines, current may be measured at the two ends of the electrode line. In an MTDC-system, also a combination of DMR lines and electrode lines are possible.

The converter may be a modular multilevel converter as disclosed in connection with the method. The HVDC system may be a multi-terminal HVDC system or a point-to-point system, for example. The HVDC system may comprise two current measuring devices for measuring current at two locations in the DMR line or EL.

Every feature described with respect to one of the aspects and embodiments is also disclosed herein with respect to the other aspects and embodiments, even if the respective feature is not explicitly mentioned in this context.

Further features, refinements and expediencies become apparent from the following description of the exemplary embodiments in connection with the figures. In the figures, elements of the same structure and/or functionality may be referenced by the same reference signs. It is to be understood that the embodiments shown in the figures are illustrative representations and are not necessarily drawn to scale.
Figure 1 shows an embodiment of a multi-terminal HVDC system in a schematic view,
Figure 2 shows a detailed view of an embodiment of a bipolar HVDC system with fault detection,
Figure 3 shows a flowchart for a method of detecting a fault in a DMR line,
Figure 4A shows a DC pole voltage at a converter station,
Figure 4B shows a DMR current measured at a converter station and at a switching station caused by the DC pole voltage of Fig. 4A,
Figure 4C shows RMS values of the currents of Figure 4B,
Figure 4D shows a difference in the RMS values of Figure 4C and shows a threshold value,
Figure 4E shows the logic for activating harmonic current control and an indication of an earth fault for the voltages and currents of Figures 4A to 4D,
Figure 5 shows a further embodiment of an HVDC system in a schematic view.

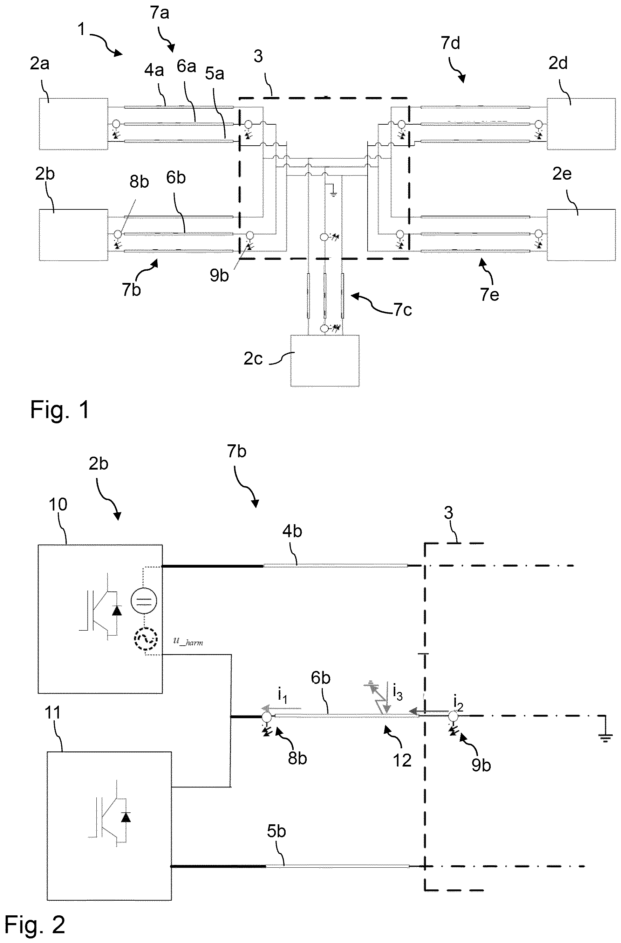

Figure 1 shows an embodiment of an HVDC system 1. The HVDC system 1 is a multi-terminal HVDC system, i.e., an HVDC system 1 with more than two terminals. The terminals can also be denoted as converter stations 2a-2e. In each of the converter stations 2a-2e, AC current is converted to DC current for transmission via a respective DC link 7a-7e to a switching station 3 or vice versa. The shown MTDC system comprises five DC links 7a-7e. The switching station 3 routes and protects part of the HVDC system 1. In particular, the switching station 3 connects the converter stations 2a-2e. The DC links 7a-7b can be also denoted as different sections of a DMR.

Each DC link 7a-7e comprises a positive first transmission line 4a, a negative second transmission line 5a and a DMR line 6a. The DMR line 6a is provided as a return path when one of the transmission lines 4a, 5a fails and the DC link 7a-7e is switched from bipolar mode to monopolar mode. Furthermore, the DMR 6a may take up unbalanced currents in bipolar mode.

For detecting a fault in a DMR line 6a, the HVDC system 1 for each DC link 7a-7e comprises a current measuring device 8b for measuring current in the vicinity of the converter station 2a of the respective DMR 6a. Additionally, a current measuring device 9b for measuring current in the vicinity of the switching station 3 is provided (in the shown embodiment only the current measuring device 8b, 9b in DC link 7b are denoted by reference signs).

The HVDC system 1 is configured for generating a small AC current in one or both transmission lines 4b, 5b during bipolar operation. By measuring the current at the shown locations by the measuring devices 8b, 9b, a fault in the DMR 6b can be detected. In particular, the value of an AC current generated in the DMR 6b due to the AC currents generated in the transmission lines 4b, 5b is measured. The currents may be measured by any known methods and devices, including optical, electromagnetic, inductive and resistive measurement devices. The functionality of the fault detection will be described in connection with the following Figures in greater detail.

In alternative embodiments, the HVDC system 1 may only comprise two terminals, i.e. two converter stations which are connected by one DC link. Such a system is also denoted as a point-to-point HVDC transmission system. In this case, currents can be measured in the vicinity of the two converter stations.

Figure 2 shows a detailed view of one of the converter stations 2b, the respective DC link 7b and the switching station 3. The AC current in the DMR line 6b is generated by an AC voltage uₕₐᵣₘ generated by one of the converters 10, 11 in the converter station 2b.

It is also possible that AC currents are generated by both converters 10, 11 so that an AC current is superimposed on the DC current in both transmission lines 4b, 5b. Alternatively, an AC current may be generated by only one of the converters 10, 11 and superimposed on the DC current in only one of the transmission lines 4b, 5b.

The converter 10 may be a MMC (Modular Multilevel) converter that comprises multiple identical submodules (SMs) that are connected in series within each phase leg. Each submodule may contain a capacitor and semiconductor switch (such as IGBTs or MOSFETs). The converter 10, particularly an MMC converter, allows regulating AC side voltage u*ᵥ* and DC side voltage u*_{vc}* in a decoupled way, wherein the voltages u*ᵥ*, u*_{vc}* can be controlled by adjusting the number of cells inserted or bypassed in the positive and negative valve arms. Thus, creating an AC harmonic current in the DMR line 6b will not affect the power transfer on any of the poles, which allows decoupled AC voltage or current control and DC voltage or current control.

A harmonic current iₕₐᵣₘ which circulates in the DC side is created by generating a harmonic voltage uₕₐᵣₘ at the DC side of the converter 10 in the converter station 2b for which the DMR health status is to be checked.

For minimizing undesired disturbances, the injected neutral line current can be selected to be at a low frequency, for example 100 Hz. Also, a low amplitude can be selected. Furthermore, the harmonic current can be created for a short time duration, for example for 0.2 s. The harmonic current may be created at regular intervals, e.g. on a daily base in a selected specific time, e.g. in the night, e.g. midnight. The duration of the harmonic current is limited to a duration which is sufficient to evaluate if an earth fault is present in the DMR. Thus, daily checking can be performed with minimal impact.

The current in the DMR line 6b is measured by current measuring devices 8b, 9b. The current may be measured in the vicinity of the converter station 2b and the switching station 3. In case of no fault in the DMR 6b, the currents i₁, i₂ measured at these locations would have similar values. In case of a fault in the DMR 6b, the currents i₁, i₂ would have different values. As an example, the difference in RMS (Root Mean Square) of the currents i₁, i₂ is determined and compared with a threshold value. If the difference is above the threshold value for a pre-defined time, a DMR fault is determined to be present.

Instead of RMS values, other current values can be used for calculating the difference, such as maximum values and/or absolute values. The threshold value can be set based on simulation studies. Some margin is kept for taking into account transients in the system and leakage in DC transmission lines (overhead lines/cable).

In the shown figure, a fault 12 is located in the DMR line 6b between the measuring positions. Due to the fault, a harmonic current i₃ flows over earth at the location of the fault 12, causing a difference between i₁ and i₂.

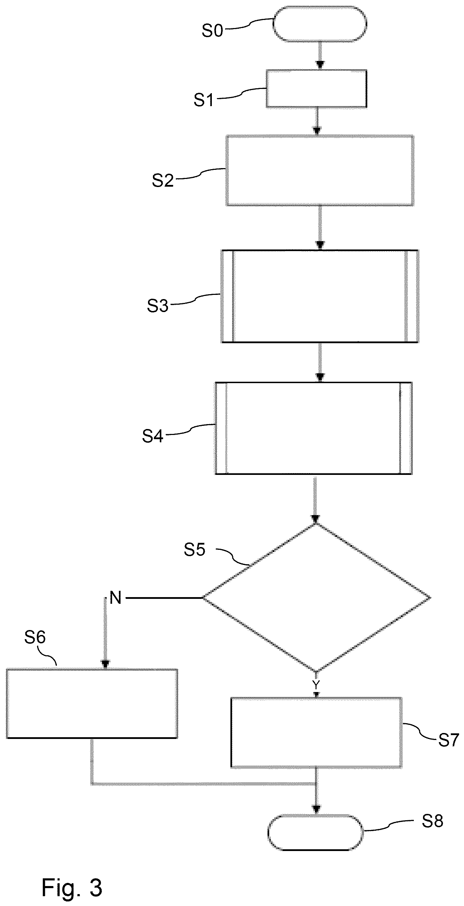

Figure 3 shows a flowchart for a method of detecting a fault in a DMR line.

After the start S0 of the method and for the desired generation S1, at a specified time, a harmonic current iₕₐᵣₘ is generated in the DMR 6b (S2).

At step S3, the current i₁ at the side of the converter station 2b and the current i₂ at the remote end, i.e., at the side of the switching station 3, are measured.

At step S4, the difference of the RMS values i_{1RMS}, i_{2RMS} of these two currents i₁, i₂ are calculated.

At step S5, it is determined if the difference is higher than a threshold value. It may be also determined if the difference is higher for a predefined time duration. The time duration may be in the range of ms.

In case the difference is not higher (N) than the threshold value for a predefined time, it is determined that the DMR is healthy (S6). In case the difference is higher (Y) than the threshold value for a predefined time, it is determined that a fault in the DMR exists (S7).

The measurement and generation of AC current may be stopped (S8) and repeated at a later time, e.g. in predefined intervals. In case the DMR line is determined to be faulty, the DMR line can be checked on-site and maintenance or repair work can be conducted.

In an MTDC system, the method can be applied sequentially to different converters so that different DMR line or Els can be examined regularly and systematically, for example each converter once in 24 hours.

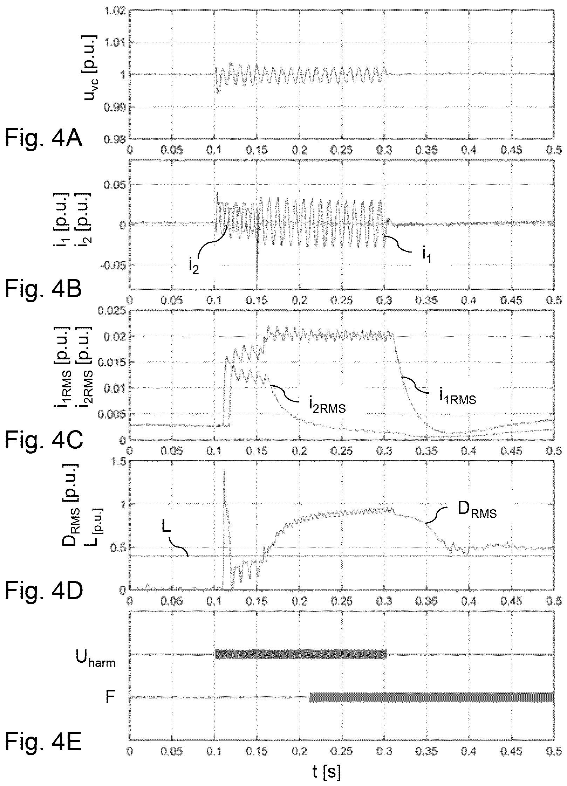

Figures 4A to 4E shows simulation of values of voltage, currents, RMS of currents, differences in the RMS values and a logic in fault detection. The voltages and currents may be generated in a bipolar HVDC system and in the described method, for example as shown in the foregoing Figures.

Figure 4A shows a DC pole voltage u*_{vc}* at a converter in a converter station. For detecting a fault in a DMR, a harmonic voltage uₕₐᵣₘ is added to the DC voltage at a time t = 0.1 s. The harmonic voltage is added for a duration of 0.2 s in the shown simulation.

Figure 4B shows a DMR current i₁ generated due to the harmonic voltage uₕₐᵣₘ in the DMR shown in Fig. 4A. The current i₁ is measured at one of the converter stations. Furthermore, a DMR current i₂ measured at the switching station is depicted. The measurement value i₂ can be communicated to a control and/or fault detector in the converter station, for example. The communication may be via a optical fiber cables along the dc cable or a wireless connection, for example.

As can be seen in Fig. 4B, the current i₂ changes abruptly at a time t=0.15 s, in particular the absolute value abruptly decreases. At the same time, also current i₁ changes.

Fig. 4C shows the RMS values i_{1RMS}, i_{2RMS} of the currents i₁ and i₂ of Fig. 4B. The RMS values i_{1RMS}, i_{2RMS} may be determined by a calculation module of a fault detector in the converter station or a remote fault detector in a monitoring station, for example.

Figure 4D shows a difference D_{RMS} in the RMS values i_{1RMS}, i_{2RMS} of Figure 4C and a threshold value. The difference D_{RMS} is shown in p.u. unitized with respect to i_{1RMS}, i.e. D_{RMS} =(i_{1RMS} - i_{2RMS})/i_{1RMS}. The threshold value L may be at 0.04 p.u., for example. The AC currents may be between 0.01 p.u. and 0.1 p.u., and nominal at 0.05 p.u., for example.

Without an earth fault, at a time between 0.1 and 0.15s, the difference D_{RMS} in RMS values i_{1RMS}, i_{2RMS} of the two currents i₁ and i₂ at the two different ends of one section of the DMR is lower than the pre-defined threshold level. Therefore, the DMR is indicated to be fault-free. As soon as an earth fault is applied, the RMS value difference D_{RMS} of the two currents i₁ and i₂ is higher than the pre-defined threshold level L. When the difference D_{RMS} is higher for a pre-defined duration, 0.05 s in the given example, a presence of an earth fault is indicated.

Figure 4E shows the logic for activating harmonic control for generating the harmonic current at a time between 0.1 s and 0.3 s as shown in Figure 4A and an indication of an earth fault once the RMS value is above the threshold value L for a pre-defined duration as shown in Fig. 4D.

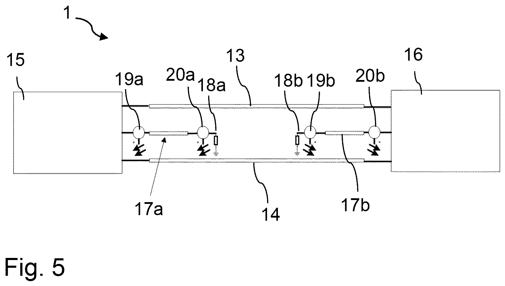

As mentioned earlier, the fault location scheme is also applicable to a point-to-point HVDC system and/or a system with an electrode line (EL) as shown in Fig. 5. In this case, the remote current signal is sent from the other converter.

Generally, the advantage of generating AC currents instead of adding small additional DC currents in the DMR is that current control is more complex in an MTDC system, because of the complex power flow scenarios. Furthermore, if power is increased on one or two poles for creating an imbalance, and if both poles operate at full power transfer, an overload condition would be created during unbalanced operation on at least one pole.

Furthermore, in case of integrating remote renewable power such as wind or solar power in an HVDC system, the HVDC converter often operate at frequency and voltage control in order to form an islanded generation grid voltage. This means that the HVDC converter will transfer whatever power generated by wind or sun from islanded grid to DC side at the rectifier or sending station. At the inverter station the converter has to control the DC voltage. In this way, power will be automatically transferred from the DC to the AC side. Therefore, adjusting power between poles may be not possible. Furthermore, in an MTDC, adjusting poles for a section of the DC link becomes even more difficult since not only the limitations in control exist due to integration of renewable energy sources but also has further constraints from other terminals. Therefore, creating currents in the DMR by adjusting pole power flow may not be feasible.

Figure 5 shows a further embodiment of an HVDC system 1 in a schematic view. In this case, the HVDC system 1 is a point-to-point system, wherein both ends of the transmission lines 13, 14 are connected to converter stations 15, 16. A further difference to the embodiment of Fig. 1 is that the HVDC system 1 comprises electrode lines 17a, 17b and earth as a return path instead of a DMR line.

A first electrode line 17a forms a connection from the first converter station 15 to a ground electrode 18a. A second electrode line 17b forms a connection from the second converter station 16 to a ground electrode 18b. Between the ground electrodes 18a, 18b a return current path is via earth. As an example, each of the electrode lines 18a, 18b may have a length of 50 km and the path via earth may have a length of 300 km. The electrode lines may be configured as overhead lines, for example.

For detecting a fault in the return path, the HVDC system 1 comprises four current measuring devices 19a, 20a, 19b, 20b. For each electrode line 17a, 17b, a first current measuring device 19a, 19b is positioned near one end of the respective electrode line 17a, 17b at the converter station 15, 16 and a second current measuring device 29a, 20b is positioned near the opposite end at the respective ground electrode 18a, 18b.

As in the foregoing embodiments, a small AC current can be caused in the electrode lines 17a, 17b and for each electrode line 17a, 17b a fault in the electrode line 17a, 17b can be detected by measuring a difference in the currents at the two ends of the respective electrode line 17a, 17b. In principle, it is also possible that only one of the electrode lines 17a, 17b is monitored by two current measurement devices.

The further functionalities including the calculation of difference in currents are as described for the embodiments comprising the DMR line. Also in the embodiment with the electrode lines 17a, 17b, the HVDC system 1 may be configured as an MTDC system instead of a point-to-point system.

### Reference Signs

1 HVDC system
2a-2e converter station
3 switching station
4a-4e first transmission line
5a-5e second transmission line
6a-6e dedicated metallic return (DMR) line
7a-7e DC link
8b first current measuring device
9b second current measuring device
10 converter
11 converter
12 fault
13 first transmission line
14 second transmission line
15 converter station
16 converter station
17a electrode line
17b electrode line
18a ground electrode
18b ground electrode
19a, 20a first current measuring device19b, 20b second current measuring device
u*ᵥ* AC side voltage
u*_{vc}* DC side voltage
uₕₐᵣₘ harmonic voltage in DMR
iₕₐᵣₘ harmonic current in DMR
i₁ current value at first location
i₂ current value at first location
i current
i_{1RMS} RMS value of current at first location
i_{2RMS} RMS value of current at first location
L threshold level
D_{RMS} difference of RMS values
F fault indication logic
Uₕₐᵣₘ harmonic voltage generation logic

## Claims

1. A method of detecting a fault in a DMR line (6a-6e) or in an electrode line (17a, 17b) in a bipolar HVDC system (1), comprising:
creating an AC current (iₕₐᵣₘ) in the DMR line (6a-6e) or in the electrode line (17a, 17b), measuring currents (i₁, i₂) at two or more locations in the DMR line (6a-6d) or in the electrode line (17a, 17b), calculating a difference (D_{RMS}) between the currents (i₁, i₂) and determining if the difference (D_{RMS}) is larger than a pre-defined threshold level (L) for detecting a fault (12) in the DMR line (6a-6e) or in the electrode line (17a, 17b).

2. The method of claim 1,
wherein the difference is calculated between RMS values (i_{1RMS}, i_{2RMS}) of the measured currents (i₁, i₂).

3. The method of any of the preceding claims,
wherein a fault (12) is detected when the difference (D_{RMS}) exceeds the threshold value (L) for a pre-defined duration.

4. The method of any of the preceding claims,
wherein the AC current (iₕₐᵣₘ) is caused by an AC voltage (uₕₐᵣₘ) generated by a converter (10, 11) in a converter station (2a-2e, 15, 16).

5. The method of claim 4,
wherein the converter (10, 11) is a modular multilevel converter.

6. The method of any of the preceding claims,
wherein the AC current (iₕₐᵣₘ) is generated for a duration of not more than 1 s.

7. The method of any of the preceding claims,
wherein the frequency of the AC current (iₕₐᵣₘ) is smaller than 200 Hz.

8. The method of any of the preceding claims,
wherein the current (i₁, i₂) is measured at a converter station (2a-2e, 15, 16).

9. The method of any of the preceding claims,
wherein the HVDC system (1) is a multi-terminal HVDC system.

10. The method of claim 10,
wherein the AC current (iₕₐᵣₘ) is introduced sequentially in different DMR lines (6a-6e) or electrode lines (17a, 17b).

11. A bipolar HVDC system (1), comprising
a first transmission line (4a-4e, 13), a second transmission line (5a-5e, 14) and a DMR line (6a-6e) or an electrode line (17a, 17b),
a converter station (2a-2e, 15, 16) comprising a converter (10, 11) configured for causing an AC current (iₕₐᵣₘ) in the DMR line (6a-6d) or the electrode line (17a, 17b),
at least one current measuring device (8b, 9b, 19a, 19b, 20a, 20b) for measuring currents (i₁, i₂) in the DMR line (6a-6e) or the electrode line (17a, 17b) at two or more locations in the DMR line (6a-6e) or the electrode line (17a, 17b),
and a fault detector configured for calculating a difference (D_{RMS}) between the currents (i₁, i₂) and determining if the difference (D_{RMS}) is larger than a pre-defined threshold level (L) for detecting a fault (12) in the DMR line (6a-6e) or in the electrode line (17a, 17b).

12. The HVDC system (1) of claim 11,
wherein the fault detector is configured for calculating RMS values (i_{1RMS}, i_{2RMS}) of the currents (i₁, i₂) and calculating a difference (D_{RMS}) between the RMS values (i_{1RMS}, i_{2RMS}).

13. The HVDC system (1) of any of claims 11 or 12, comprising a DMR line (6a-6e), wherein the fault detector is configured for detecting a fault in the DMR line (6a-6e).

14. The HVDC system (1) of any of claims 11 to 13, comprising an electrode line (17a, 17b), wherein the fault detector is configured for detecting a fault in the electrode line (17a, 17b).

15. The HVDC system (1) of any of claims 11 to 14,
being a multi-terminal HVDC system.
